# EUROPÄISCHE PATENTANMELDUNG

(11) **EP 1 732 140 A1**
(43) Veröffentlichungstag der Anmeldung: **13.12.2006**
(21) Anmeldenummer: 05405369.9
(22) Anmeldetag: 06.06.2005
(51) Int. Cl.: H01L 31/042, H01L 31/045, H01L 31/048

(54) **Flexibles Substrat mit Photovoltaik-Zellen und daraus hergestelltes Modul**

(71) Anmelder: Alcan Technology & Management Ltd., 8212 Neuhausen am Rheinfall (CH)
(72) Erfinder: Hotz, Walter, 8222 Beringen (CH)

(57) **Zusammenfassung**

Bei einem flexiblen Substrat mit einem Kunststofffilm (12) und auf dem Kunststofffilm mittels Vakuum-Dünnschichttechnik abgeschiedenen Photovoltaik (PV)-Zellen ist das Substrat eine Verbundfolie aus wenigstens einem Kunststofffilm (12) und wenigstens einer Metallfolie (14). Die Metallfolie fixiert den Kunststofffilm über die gesamte Oberfläche, verhindert damit ein temperaturbedingtes Schrumpfen des Films bei den hohen Abscheidungstemperaturen und ermöglicht die Verwendung eines kostengünstigen Kunststoffmaterials. Bei einem Photovoltaik (PV)-Modul mit auf dem Kunststofffilm mittels Vakuum-Dünnschichttechnik abgeschiedenen Schichten umfassend eine erste elektrisch leitende Kontaktschicht (16), eine Schicht mit PV-Zellen (18) und eine zweite elektrisch leitende Kontaktschicht (20) bilden die Metallfolien (14, 24) zwei mit den elektrisch leitenden Kontaktschichten (16, 20) verbundene elektrische Leiter.

## Beschreibung

Die Erfindung betrifft ein flexibles Substrat aus einem Kunststofffilm und auf dem Kunststofffilm mittels Vakuum-Dünnschichttechnik abgeschiedenen Photovoltaik (PV)-Zellen. Weiter betrifft die Erfindung ein Photovoltaik-Modul mit einem flexiblen Substrat aus einem Kunststofffilm und auf dem Kunststofffilm mittels Vakuum-Dünnschichttechnik abgeschiedenen Schichten umfassend nacheinander eine erste elektrisch leitende Kontaktschicht, eine Schicht mit PV-Zellen und eine zweite elektrisch leitende Kontaktschicht.

Die Abscheidung amorpher PV-Zellen auf einem Kunststofffilm ermöglicht die kontinuierliche Herstellung von PV-Modulen in Bandform. Die bei einer Beschichtung mittels Vakuum-Dünnschichttechnik auf den Kunststofffilm einwirkenden Abscheidungstemperaturen liegen in einem Bereich von etwa 200 bis 250 °C. Bei diesen Temperaturen schrumpfen praktisch alle in Frage kommenden preisgünstigen Kunststofffilme, wie z. B. Filme aus Polyethylenterephthalat (PET). Als Substrat zur Abscheidung amorpher PV-Zellen können daher nur ausreichend temperaturbeständige Filme eingesetzt werden. Bekannt ist die Verwendung von Polyimid-Filmen, die allerdings gegenüber Filmen mit geringerer Temperaturbeständigkeit wesentlich teurer sind.

Der Erfindung liegt die Aufgabe zugrunde, ein zur Abscheidung von PV-Zellen mittels Vakuum-Dünnschichttechnik geeignetes flexibles Substrat der eingangs genannten Art bereitzustellen, welches kostengünstiger ist als die heute eingesetzten, bei den Abscheidungstemperaturen formbeständigen Kunststofffilme. Ein weiteres Ziel der Erfindung ist die Schaffung eines Moduls mit einem flexiblen Substrat der eingangs Art, welches auf einfache Weise eine Ableitung des durch die PV-Zellen erzeugten elektrischen Stroms über elektrische Leiter ermöglicht.

Zur erfindungsgemässen Lösung der Aufgabe führt, dass das Substrat eine Verbundfolie aus wenigstens einem Kunststofffilm und wenigstens einer Metallfolie ist.

Der wesentliche Kern der Erfindung liegt in der Fixierung des zur Abscheidung der PV-Zellen vorgesehenen Kunststofffilms mit einem kostengünstigen, bei den Abscheidungstemperaturen formbeständigen Material. Die als formbeständiges Material eingesetzte Metallfolie stabilisiert den mit der Metallfolie verklebten Kunststofffilm über die gesamte Oberfläche und verhindert ein temperaturbedingtes Schrumpfen des Kunststofffilms.

Ein weiterer wesentlicher Vorteil von Metallfolien liegt darin, dass sie als elektrische Leiter für die elektrische Kontaktierung der PV-Zellen und die Ableitung des durch die PV-Zellen erzeugten elektrischen Stroms eingesetzt werden können.

Das Substrat kann eine Verbundfolie aus einer Metallfolie mit beidseitig angeordneten Kunststofffilmen sein. Die Metallfolie ist auf diese Weise vor Korrosion und anderen schädlichen Umwelteinflüssen geschützt und ist gleichzeitig auf beiden Seiten elektrisch isoliert. Die Metallfolie kann auch in zwei elektrische Leiter aufgeteilt sein.

Das Substrat kann auch eine Verbundfolie aus alternierend angeordneten Kunststofffilmen und Metallfolien sein, wobei zweckmässigerweise zwei Metallfolien als elektrische Leiter für die elektrische Kontaktierung der PV-Zellen dienen.

Die Kunststofffilme können aus irgendeinem Kunststoff sein und grundsätzlich auch einen mehrschichtigen Aufbau aufweisen. Besonders bevorzugt werden jedoch Filme aus Polyethylenterephthalat (PET).

Bevorzugte Metallfolien sind Folien aus Aluminium oder Aluminiumlegierungen und werden hier allgemein als Aluminiumfolien bezeichnet.

Die aus einem oder mehreren Kunststofffilmen und einer oder mehreren Metallfolien bestehenden Verbundfolien sind üblicherweise über einen Kleber, z.B. einen Kleber auf der Basis von Polyurethan, miteinander verbunden.

Verbundfolien aus einem PET-Film und einer Aluminiumfolie werden als Verpackungsmaterialien in grossen Mengen als Rollenware hergestellt und sind daher ein kostengünstiges Ausgangsmaterial zur Herstellung des erfindungsgemässen Substrats.

Aus dem erfindungsgemässen flexiblen Substrat wird bevorzugt ein Photovoltaik-Modul mit einer ersten elektrisch leitenden Kontaktschicht, einer Schicht mit PV-Zellen und einer zweiten elektrisch leitenden Kontaktschicht hergestellt, wobei die Metallfolien mit den elektrisch leitenden Kontaktschichten verbundene elektrische Leiter bilden.

Weitere Vorteile, Merkmale und Einzelheiten der Erfindung ergeben sich aus der nachfolgenden Beschreibung bevorzugter Ausführungsbeispiele sowie anhand der Zeichnung; diese zeigt schematisch in
- Fig. 1 einen Querschnitt durch ein erstes flexibles Substrat mit einer PV-Schicht;
- Fig. 2 einen Querschnitt durch ein zweites flexibles Substrat mit einer PV-Schicht;
- Fig. 3 - 5 die Herstellungsstufen einer ersten Ausführungsform eines Substrats mit einer aus einer Vielzahl von Einzelzellen aufgebauten PV-Schicht im Querschnitt;
- Fig. 6 eine Draufsicht auf das Substrat von Fig. 5;
- Fig. 7 einen Querschnitt durch eine erste Ausführungsform eines Substrats mit einer PV-Monozelle;
- Fig. 8 einen Querschnitt durch eine zweite Ausführungsform eines Substrats mit einer PV-Monozelle;
- Fig. 9-11 die Herstellungsstufen einer zweiten Ausführungsform eines Substrats mit einer aus einer Vielzahl von Einzelzellen aufgebauten PV-Schicht im Querschnitt;
- Fig. 12 - 14 die Herstellungsstufen einer dritten Ausführungsform eines Substrats mit einer aus einer Vielzahl von Einzelzellen aufgebauten PV-Schicht im Querschnitt.

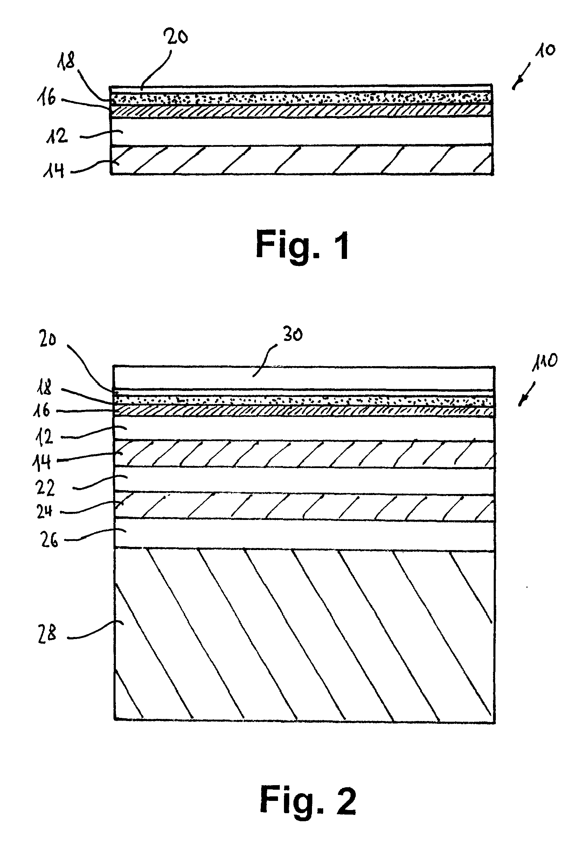

Ein in Fig. 1 gezeigtes flexibles Substrat 10 weist einen Kunststofffilm 12 aus Polyethylenterephthalat (PET) auf. Der PET-Film 12 ist auf einer Seite mit einer Aluminiumfolie 14 verbunden. Auf der anderen Seite des PET-Films 12 sind übereinander eine erste elektrisch leitende Kontaktschicht 16, eine Photovoltaik-Schicht 18 aus einer Vielzahl von PV-Zellen oder einer einzigen PV-Monozelle, und eine zweite elektrisch leitende Kontaktschicht 20 angeordnet. Die Herstellung dieser drei Schichten erfolgt durch Abscheidung der entsprechenden Schichtbestandteile mittels Vakuum-Dünnschichttechnik.

Die erste elektrisch leitende Schicht 16 ist eine metallische Schicht aus Aluminium. Die zweite elektrisch leitende Schicht 20 ist für sichtbares Licht transparent und besteht aus ggf. gedopten Metalloxiden. Derartige Schichten sind weit verbreitet und unter dem Namen Transparent Contacting Oxide (TCO) bekannt. Die beiden elektrisch leitenden Schichten 16, 20 dienen der elektrischen Kontaktierung der beiden Pole der Zellen der PV-Schicht 18.

Die Aluminiumfolie 14 stabilisiert den mit ihr verbundenen PET-Film 12 während der Abscheidung der Schichten 16, 18 und 20 aus dem Vakuum und verhindert insbesondere ein Schrumpfen des PET-Films 12 unter dem Einfluss der bei den Abscheidungsvorgängen erzeugten Wärme.

Ein in Fig. 2 dargestelltes weiteres flexibles Substrat 110 weist ebenfalls die aus Fig. 1 bekannte Schichtfolge Aluminiumfolie 14 / PET-Film 12 / Aluminium-Kontaktschicht 16 / PV-Schicht 18 / TCO-Kontaktschicht 20 auf. Zusätzlich folgt auf die Metallfolie 14 ein zweiter PET-Film 22, auf diesen eine zweite Aluminiumfolie 24 und auf diese ein dritter PET-Film 26. Wie weiter unten näher erläutert, dienen die zur Stabilisierung des ersten PET-Films 12 vorgesehene Aluminiumfolie 14 und die von dieser durch den zweiten PET-Film 22 getrennte und elektrisch isolierte zweite Aluminiumfolie 24 als elektrische Leiter zur elektrischen Kontaktierung der Zellen der PV-Schicht 18. Der dritte PET-Film 26 dient zur elektrischen Isolation der zweiten Aluminiumfolie 24 und schützt diese gleichzeitig vor Korrosion und anderen schädlichen Umwelteinflüssen.

Das Substrat 110 ist über den dritten PET-Film 26 auf ein Trägermaterial 28, beispielsweise ein Aluminiumblech, eine Leichtbauplatte oder ein Sandwich-Verbundmaterial, geklebt oder gesiegelt. Eine über der TCO-Kontaktschicht 20 angeordnete Schutzschicht 30 aus einem lichtdurchlässigen, gegen mechanische Beschädigungen schützenden und gegebenenfalls texturierten Kunststoff ist mit dem Trägermaterial 28 oder mit dem dritten PET-Film längs eines umlaufenden Randes verklebt oder versiegelt und umschliesst ein PV-Modul hermetisch.

Die Verbindung zwischen den PET-Filmen und den Aluminiumfolien erfolgt üblicherweise mittels eines Klebers in der Form einer Klebstoffschicht, eines Klebstofffilms oder als Extrusionskaschierung.

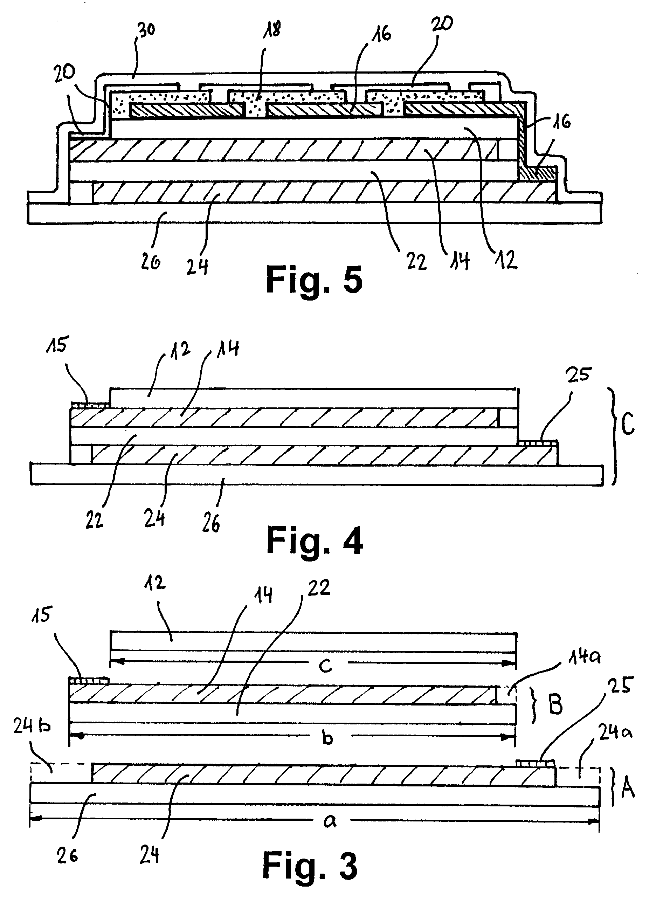

Die Herstellung eines PV-Moduls wird nachfolgend anhand der Fig. 3 bis 6 näher erläutert.

Gemäss Fig.3 werden bei einem in Form eines Bandes mit einer Breite a vorliegenden Laminat A aus dem dritten PET-Film 26 und der zweiten AluminiumFolie 24 beidseitig Randstreifen 24a, 24b der Aluminiumfolie 24 weggeätzt. Auf der in der Zeichnung rechten Seite wird die Aluminiumfolie 24 mit einem Abdeckstreifen 25 abgedeckt.

In einem zweiten Schritt wird ein in Form eines Bandes mit einer Breite b vorliegendes Laminat B aus dem zweiten PET-Film 22 und der ersten Aluminiumfolie 14 mit dem Laminat A verbunden. Die Breite b des Laminates B ist kleiner als die Breite a des Laminates A, so dass der nun mit der zweiten Aluminiumfolie 24 verbundene zweite PET-Film 22 auf der rechten Seite unmittelbar an den Abdeckstreifen 25 angrenzt und auf der linken Seite die zweite Aluminiumfolie 24 überragt. Beim Laminat B ist auf der rechten Seite ein Randstreifen 14a der ersten Aluminiumfolie 14 weggeätzt, und der linke Rand der ersten Aluminiumfolie 14 ist mit einem Abdeckstreifen 15 abgedeckt.

In einem weiteren Schritt wird der in Form eines Bandes mit einer Breite c vorliegende PET-Film 12 so mit dem Laminat B verbunden, dass er am linken Rand unmittelbar an den Abdeckstreifen 15 anschliesst und am rechten Rand den weggeätzten Randstreifen 14a der ersten Aluminiumfolie 14 überdeckt. Das auf diese Weise hergestellte Laminat C ist in Fig. 4 dargestellt.

In einem nächsten Schritt wird der Abdeckstreifen 25 von der zweiten Aluminiumfolie 24 entfernt und der erste PET-Film 12 sowie der rechte Seitenrand des Laminates C mit der Aluminium-Kontaktschicht 16 mittels Vakuum-Dünnschichttechnik beschichtet. Auf diese Weise entsteht am rechten Rand des Laminates C eine elektrisch leitende Verbindung zwischen der Aluminium-Kontaktschicht 16 auf dem ersten PET-Film 12 und der zweiten Aluminiumfolie 24.

Als nächster Schritt folgt die Abscheidung der PV-Schicht 18 mittels Vakuum-Dünnschichttechnik auf die Aluminium-Kontaktschicht 16. Nach dem Entfernen des Abdeckstreifens 15 wird die TCO-Kontaktschicht 20 auf die PV-Schicht 18 und am linken Rand auf die freiliegende Aluminiumfolie 14 abgeschieden. Auf diese Weise entsteht am linken Rand des Laminates C eine Verbindung zwischen der TCO-Kontaktschicht 20 und der ersten Aluminiumfolie 14. Das derart mit PV-Zellen beschichtete Laminat C ist in Fig. 5 dargestellt.

Zum Schutz der abgeschiedenen Schichten 16, 18, 20 vor schädlichen Umwelteinflüssen und mechanischer Verletzungen wird das beschichtete Substrat mit einer lichtdurchlässigen Schutzschicht 30 versehen. Die Schutzschicht 30 wird an den Seitenrändern gegen den dritten PET-Film 26 gesiegelt.

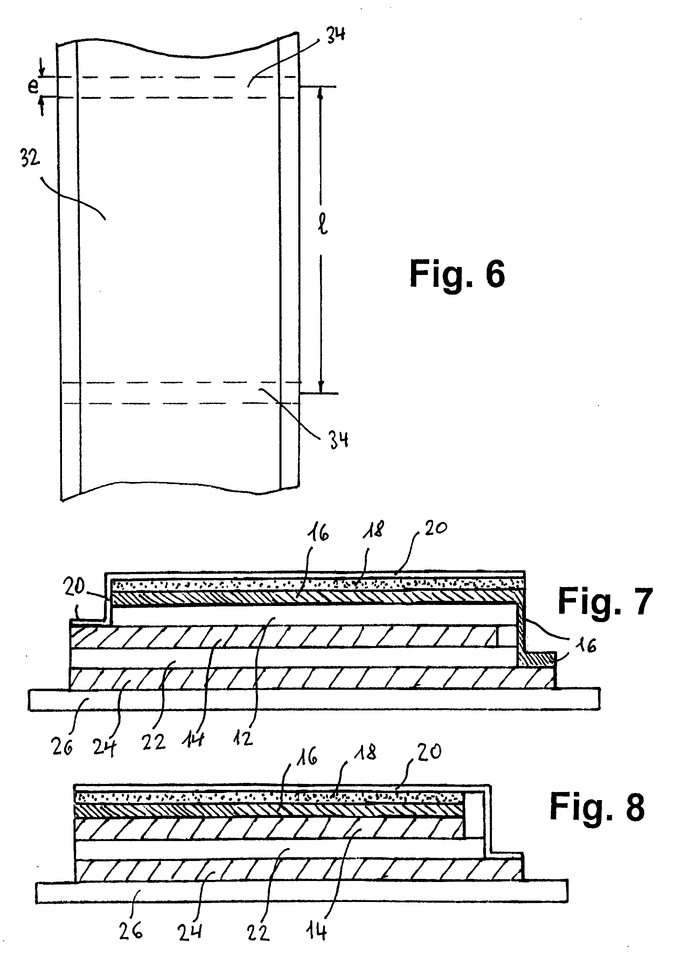

Das in Bandform vorliegende Produkt kann gemäss Fig. 6 in einzelne PV-Module 32 von beliebiger Länge I unterteilt werden. Hierzu wird nach der jeweils gewünschten Länge I eines PV-Moduls 32 ein Querstreifen 34 einer Breite e nicht beschichtet. Die Trennung in die einzelnen PV-Module 32 kann durch einfaches Schneiden des Bandes innerhalb der Querstreifen 34 erfolgen. Die Kontaktierung der PV-Module 32 mit der ersten Aluminiumfolie 14 erfolgt im linken Randstreifen und mit der zweiten Aluminiumfolie 24 im rechten Randstreifen (Fig. 5).

In den Fig. 7 und 8 sind zwei nach dem in den Fig. 3 bis 5 beschriebenen Verfahren hergestellte Substrate mit einer PV-Monozelle dargestellt.

Bei der in Fig. 7 gezeigten Ausführungsform ist die Aluminium-Kontaktschicht 16 auf dem ersten PET-Film 12, auf der rechten Seite am Seitenrand des Laminates und auf einem Randstreifen der zweiten Aluminiumfolie 24 abgeschieden und so mit der zweiten Aluminiumfolie 24 elektrisch leitend verbunden. Die auf der PV-Schicht 18 abgeschiedene TCO-Kontaktschicht 20 ist auf der linken Seite am Seitenrand und auf einem Randstreifen der ersten Aluminiumfolie 14 abgeschieden und so mit der ersten Aluminiumfolie 14 elektrisch leitend verbunden.

Bei der in Fig. 8 gezeigten Variante ist die Aluminium-Kontaktschicht 16 direkt auf der ersten Aluminiumfolie 14 abgeschieden. Die TCO-Kontaktschicht 20 ist in diesem Fall auf der rechten Seite am Seitenrand des Laminates und auf einem Randstreifen der zweiten Aluminiumfolie 24 abgeschieden und so mit der zweiten Aluminiumfolie 24 elektrisch leitend verbunden.

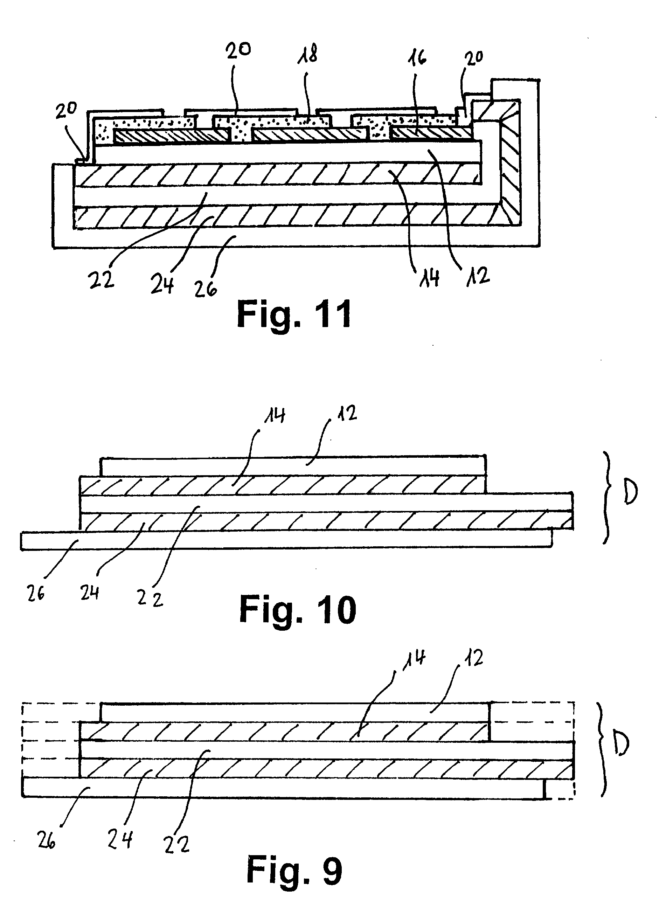

In den Fig. 9 bis 11 ist eine weitere Möglichkeit zur elektrischen Kontaktierung der PV-Schicht über die zwei Aluminiumfolien 14, 24 dargestellt.

Ein in Fig.9 gezeigtes Laminat D mit dem Aufbau dritter PET-Film 26 / zweite Aluminiumfolie 24 / zweiter PET-Film 22 / erste Aluminiumfolie 14 / erster PET-Film 12 wird an den Seitenrändern durch Schneiden bzw. Ätzen in den strichliniert dargestellten Randbereichen so bearbeitet, dass das Laminat D an den Seitenrändern die in Fig. 10 gezeigte Konfiguration aufweist. Bei diesen Seitenrandkonfigurationen können Teile der Einzelschichten an den Seitenrändern so geformt werden, dass die als elektrische Leiter dienenden Aluminiumfolien 14, 24 einerseits durch den zweiten PET-Film 22 von einander isoliert sind und andererseits eine Kontaktierung der elektrisch leitenden Schichten 16, 20 ermöglichen. Durch entsprechendes Formen der Seitenränder des Laminates D entsteht die in Fig. 11 gezeigte Konfiguration der Aluminiumfolien 14, 24 am rechten Seitenrand. Bei der nachfolgenden Abscheidung der Schichten 16, 18, 20 erfolgt auf der linken Seite die Kontaktierung der TCO-Kontaktschicht 20 mit der ersten Aluminiumfolie 14 durch Abscheidung auf einen schmalen Randstreifen der Aluminiumfolie 14. Auf der rechten Seite erfolgt die Kontaktierung der TCO-Kontaktschicht 20 durch Abscheidung auf einem schmalen Streifen der zweiten Aluminiumfolie 24.

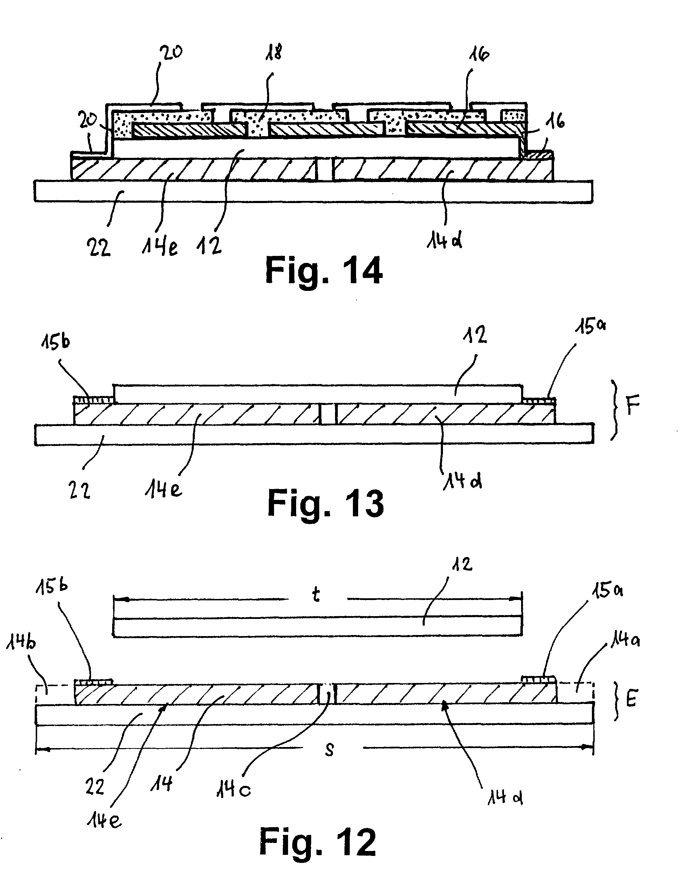

In den Fig. 12 bis 14 ist eine Möglichkeit zur elektrischen Kontaktierung der PV-Schicht über eine einzige Aluminiumfolie 14 dargestellt.

Gemäss Fig.12 werden bei einem in Form eines Bandes mit einer Breite s vorliegenden Laminat E mit dem Aufbau zweiter PET-Film 22 / Aluminiumfolie 14 an der Aluminiumfolie 14 beidseitig Randstreifen 14a, 14b und ein die Aluminiumfolie 14 in zwei Folien 14d, 14e unterteilender Mittelstreifen 14c weggeätzt. An beiden Seitenrändern wird die Aluminiumfolie 14 mit je einem Abdeckstreifen 15a, 15b abgedeckt.

In einem zweiten Schritt wird der in Form eines Bandes mit einer Breite t vorliegende erste PET-Film 12 mit dem Laminat E verbunden. Die Breite t des ersten PET-Films 12 ist kleiner als die Breite s des Laminates E, so dass der nun mit der Aluminiumfolie 14 verbundene erste PET-Film 12 beidseitig unmittelbar an die Abdeckstreifen 15a, 15b angrenzt. Das auf diese Weise hergestellte Laminat F ist in Fig. 13 dargestellt.

In einem nächsten Schritt wird der Abdeckstreifen 15a von der Aluminiumfolie 14 entfernt und der erste PET-Film 12 sowie der rechte Seitenrand des Laminates F mit der Aluminium-Kontaktschicht 16 mittels Vakuum-Dünnschichttechnik beschichtet. Auf diese Weise entsteht am rechten Rand des Laminates F eine elektrisch leitende Verbindung zwischen der Aluminium-Kontaktschicht 16 auf dem ersten PET-Film 12 und der rechten Aluminiumfolie 14d. Als nächster Schritt folgt die Abscheidung der PV-Schicht 18 mittels Vakuum-Dünnschichttechnik auf die Aluminium-Kontaktschicht 16. Nach dem Entfernen des Abdeckstreifens 15b wird die TCO-Kontaktschicht 20 auf die PV-Schicht 18 und am linken Rand auf die freiliegende linke Aluminiumfolie 14e abgeschieden. Auf diese Weise entsteht am linken Rand des Laminates F eine Verbindung zwischen der TCO-Kontaktschicht 20 und der linken Aluminiumfolie 14e. Das derart mit PV-Zellen beschichtete Substrat ist in Fig. 14 dargestellt.

## Patentansprüche

1. Flexibles Substrat aus einem Kunststofffilm (12) und auf dem Kunststofffilm mittels Vakuum-Dünnschichttechnik abgeschiedenen Photovoltaik (PV)-Zellen,
**dadurch gekennzeichnet, dass**
das Substrat eine Verbundfolie aus wenigstens einem Kunststofffilm (12) und wenigstens einer Metallfolie (14) ist.

2. Flexibles Substrat nach Anspruch 1, **dadurch gekennzeichnet, dass** das Substrat eine Verbundfolie aus einer Metallfolie (14) mit beidseitig angeordneten Kunststofffilmen (12, 22) ist.

3. Flexibles Substrat nach Anspruch 1 oder 2, **dadurch gekennzeichnet, dass** die Metallfolie (14) ein elektrischer Leiter für die elektrische Kontaktierung der PV-Zellen ist.

4. Flexibles Substrat nach Anspruch 3, **dadurch gekennzeichnet, dass** die Metallfolie (14) in zwei elektrische Leiter (14d, 14 e) aufgeteilt ist.

5. Flexibles Substrat nach Anspruch 1, **dadurch gekennzeichnet, dass** das Substrat eine Verbundfolie aus alternierend angeordneten Kunststofffilmen (12, 22, 26) und Metallfolien (14, 24) ist und zwei Metallfolien (14, 24) elektrische Leiter für die elektrische Kontaktierung der PV-Zellen sind.

6. Flexibles Substrat nach einem der Ansprüche 1 bis 5, **dadurch gekennzeichnet, dass** der/die Kunststofffilm/e (12, 22, 26) aus Polyethylenterephthalat (PET) ist/sind.

7. Flexibles Substrat nach einem der Ansprüche 1 bis 6, **dadurch gekennzeichnet, dass** die Metallfolie/n (14, 24) aus Aluminium ist/sind.

8. Photovoltaik (PV)-Modul mit einem flexiblen Substrat aus einem Kunststofffilm (12) und auf dem Kunststofffilm mittels Vakuum-Dünnschichttechnik abgeschiedenen Schichten umfassend nacheinander
- eine erste elektrisch leitende Kontaktschicht (16),
- eine Schicht mit PV-Zellen (18) und
- eine zweite elektrisch leitende Kontaktschicht (20),
**dadurch gekennzeichnet, dass**
das Substrat eine Verbundfolie aus wenigstens einem Kunststofffilm (12) und wenigstens einer Metallfolie (14) ist, wobei die Metallfolie/n (14, 24) zwei mit den elektrisch leitenden Kontaktschichten (16, 20) verbundene elektrische Leiter bildet/bilden.

9. Photovoltaik-Modul nach Anspruch 8, **dadurch gekennzeichnet, dass** das Substrat eine Verbundfolie aus einer in zwei elektrische Leiter (14d, 14e) geteilten Metallfolie (14) mit wenigstens einem auf einer der Seiten angeordneten Kunststofffilm (12, 22) ist.

10. Photovoltaik-Modul nach Anspruch 8, **dadurch gekennzeichnet, dass** das Substrat eine Verbundfolie aus alternierend angeordneten Kunststofffilmen (12, 22, 26) und Metallfolien (14, 24) ist, wobei die Metallfolien (14, 24) zwei mit den elektrisch leitenden Kontaktschichten (16, 20) verbundene elektrische Leiter bilden.

11. Photovoltaik-Modul nach einem der Ansprüche 8 bis 10, **dadurch gekennzeichnet, dass** der/die Kunststofffilm/e (12, 22, 26) aus Polyethylenterephthalat (PET) ist/sind.

12. Photovoltaik-Modul nach einem der Ansprüche 8 bis 10, **dadurch gekennzeichnet, dass** die Metallfolie/n (14, 24) aus Aluminium ist/sind.
